# EUROPEAN PATENT APPLICATION

(11) **EP 1 253 217 A1**
(43) Date of publication of application: **30.10.2002**
(21) Application number: 00942476.3
(22) Date of filing: 06.07.2000
(51) Int. Cl.: C23C 18/20

(54) **METHOD FOR PRELIMINARY TREATMENT OF MATERIAL TO BE SUBJECTED TO ELECTROLESS PLATING**

(71) Applicant: National Institute of Advanced Industrial Science and Technology, Tokyo 100-8921 (JP); Omron Corporation, Kyoto, Kyoto 600-8530 (JP)
(72) Inventor: TANAKA, H., Omron Corp., 801, Minamifudodo-cho, Kyoto-shi, Kyoto 600-8530 (JP); HIRONO, S., Omron Corp., 801, Minamifudodo-cho, Kyoto-shi, Kyoto 600-8530 (JP); NIINO, Hiroyuki, Tsukuba Center, National Inst., Tsukuba-shi, Ibaraki 305-8565 (JP); YABE, Akira, Tsukuba Center, National Inst., Tsukuba-shi, Ibaraki 305-8565 (JP)
(74) Representative: Kilian, Helmut, Dr.
(86) International application number: JP0004491
(87) International publication number: WO02004705

(57) **Abstract**

An inorganic filler is added to a polymeric material. An obtained polymeric mold is irradiated with a laser and immersed in an anionic noble metal aqueous solution and thereafter electroless plating is performed.

## Description

### TECHNICAL FIELD

The present invention relates to a pretreatment method for electroless plating.

### BACKGROUND ART

In general, a surface of a mold composed of a polymeric material is roughened by chemicals, palladium is adsorbed therein and then the mold is subjected to electroless plating. However, since adsorption of palladium alone is difficult, a tin-palladium compound is adsorbed and then reduced.

Surface roughening by using chemicals cannot be selectively performed. When only a prescribed region is plated, the whole surface is once plated and then exposure and development need to be performed by using a photoresist. Therefore, a method by which a surface of a polymeric mold can be easily plated is being required.

As described in Japanese Patent Unexamined Publication No. Hei 4-183873, a method by which a prescribed region can be plated by irradiating a mold composed of a polymeric material with ultraviolet laser beams was proposed.

According to this method, only a prescribed region can be plated only by irradiating with an ultraviolet laser, immersing in a palladium colloidal aqueous solution and then performing electroless plating. That is, since only an irradiated region is positively charged by the irradiation with an ultraviolet laser, palladium colloid can be easily attached to only the irradiated region when the mold is immersed in an anionic noble metal aqueous solution. Only palladium, which is a catalyst of electroless plating, can be deposited by allowing the aqueous solution to contain a reducing agent therein.

However, this method by laser irradiation has the following problems and is not employed currently.

That is, since only the periphery of the irradiated region (prescribed region) is charged when the laser having a high fluence is irradiated, irradiation of a low fluence needs to be performed. However, a sufficient quantity of charge is not obtained with such irradiation and thereby palladium colloid is not sufficiently attached. A substantial amount of laser beams need to be irradiated and operatability is deteriorated. Specifically, when a laser having a low fluence of 0.05 J/cm²/pulse is irradiated, the number of times of irradiation needs to be 1000 to obtain a sufficient charge quantity.

Also, when a laser having a low fluence is irradiated, surface irregularities of the irradiated region become small and thereby formed plating is easily peeled.

Furthermore, a charging phenomenon by irradiation of a low fluence is unique to an ultraviolet laser and thereby selectable equipment is limited.

Accordingly, an object of the present invention is to provide a pretreatment method for electroless plating by which a prescribed region can be efficiently and firmly plated irrespective of the kind of a laser.

### DISCLOSURE OF THE INVENTION

The present inventors found that the main cause of charging of a mold surface by laser irradiation was removed and scattered substances (hereinafter, referred to as debris) generated by abrasion. Also, the present inventors found that these debris could be prevented from scattering by allowing the mold to contain an inorganic filler.

According to the present invention, a pretreatment method for electroless plating as means for solving the aforementioned problems is provided such that an inorganic filler is added to a polymeric material and an obtained polymeric mold is irradiated with a laser and immersed in an anionic noble metal aqueous solution.

With this constitution, the added inorganic filler generates a sufficient quantity of charged debris upon laser irradiation irrespective of the level of the fluence and the debris are prevented from scattering outside the irradiated region. Therefore, when the mold is immersed in an anionic noble metal aqueous solution, noble metal can be attached only to a laser irradiated region. As a result, when electroless plating is performed, noble metal attached to the laser irradiated region acts as a catalyst and thereby a favorable plating film can be formed on a desired site (irradiated region).

### BRIEF DESCRIPTION OF THE DRAWINGS

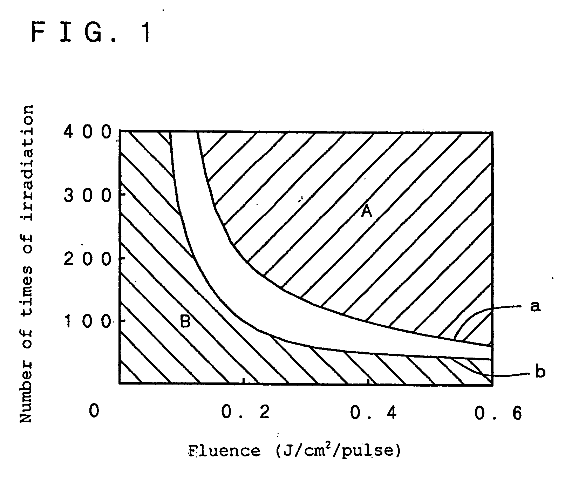

Fig. 1 is a graph showing a state of an irradiated region depending on the fluence and the number of times of irradiation.

### BEST MODE FOR CARRYING OUT THE INVENTION

An embodiment of the pretreatment method for electroless plating according to the present invention is described below.

In this pretreatment method for electroless plating, an inorganic filler is added to a polymeric material and an obtained mold is irradiated with laser.

In this case, Liquid Crystal Polymer (LCP), polyethersulfone, polybutylene terephthalate, polycarbonate, polyphenylene ether, polyphenylene oxide, polyacetal, polyethylene terephthalate, polyamide, Acrylonitrile-Butadiene-Styrene (ABS), polyphenylene sulfide, polyetherimide, polyetherether ketone, polysulfone, polyimide, epoxy resin, or a composite resin thereof or the like can be used as the polymeric material.

A glass filler, ceramic particles or the like can be mentioned as the inorganic filler. It is preferable that 10-50 weight % of fibers having a diameter ϕ of 1-20 µm and a length of 10 µm or longer or particles having a diameter ϕ of 0.5-20 µm are added to the polymeric material because debris can be further prevented from scattering.

As the laser, an excimer laser (wavelength λ = 193 nm, 248 nm, 318 nm, 351 nm), a second higher harmonic YAG laser (wavelength λ = 532 nm), a third higher harmonic YAG laser (wavelength λ = 355 nm) or the like having a wavelength of 600 nm or shorter can be used.

When the total energy inputted by the laser is 10-500 J/cm², the charging state of the laser irradiated region can be suitable for attachment of noble metal.

In particular, laser irradiation conditions such as a fluence (energy per unit pulse in a unit area: J/cm²/pulse) and the number of times of irradiation are preferably set so that a charging state becomes suitable for precipitating noble metal. Specifically, the fluence and the number of times of irradiation of laser can be set to be any value in region A in a graph shown in Fig. 1. Consequently, a charging state of debris generated by abrasion becomes favorable in a laser irradiated region. Deposition of noble metal described later is appropriately performed and thereby the whole surface of the laser irradiated region can be plated.

Subsequently, the mold is immersed in an anionic noble metal aqueous solution. In this case, as an anionic noble metal aqueous solution which can be used, a palladium aqueous solution obtained by dissolving PdCl₂ powder, Na₂PdCl₄ powder or PdCl₂ powder in ion-exchanging water, a palladium colloidal aqueous solution obtained by mixing palladium chloride, sodium chloride and polyethylene glycol mono-P-nonylphenylether, borated nonylphenyl ether and the like can be mentioned.

Thus, according to the above-described pretreatment method, noble metal can be deposited only on the laser irradiated region of a mold. When electroless plating is performed thereafter, an electroless plating film is formed only in this region.

When the polymeric material is two or more kinds of resins having different laser ablation threshold values, irregularities of a laser irradiated region can be made even larger and thereby plating can be formed in a state that peeling is even more difficult.

The pretreatment method for electroless plating according to the present invention will be described in more detail below with reference to examples.

### (Example 1)

LCP was used as a polymeric material. As an inorganic filler, 30 weight % of a glass filler having a diameter ϕ of 10 µm was added to this material. Then, this material was subjected to injection molding. A surface of the obtained mold was irradiated with laser beams by using a KrF excimer laser under conditions that the fluence is 0.2 J/cm²/pulse, the number of times of irradiation is 200 pulses and the cycle frequency is 50 Hz. Subsequently, the mold was immersed in a palladium colloidal solution obtained by mixing palladium chloride, sodium chloride and polyethylene glycol mono-P-nonylphenylether and borated nonylphenylether for 15 minutes. Subsequently, the mold was washed with ion-exchanging water and immersed in an electroless nickel solution for 15 minutes. Consequently, nickel electroless plating could be attached to the laser irradiated region. It is noted that when an inorganic filler was not added to LCP, plating couldn't be obtained by the processings under the same conditions.

### (Example 2)

PES was used as a polymeric material. 30 weight % of a glass filler having a diameter ϕ of 10 µm as an inorganic filler was added to this material. Subsequently, nickel electroless plating could be attached to the laser irradiated region by processing this under the same conditions as in Example 1. It is noted that when an inorganic filler was not added to PES, plating couldn't be obtained by the processings under the same conditions.

### (Example 3)

PC was used as a polymeric material. As a inorganic filler, 30 weight % of a glass filler having a diameter ϕ of 10 µm was added. Then, this material was subjected to injection molding. A surface of the obtained mold was irradiated with laser beams by using a KrF excimer laser under conditions that the fluence is 0.4 J/cm²/pulse, the number of times of irradiation is 1000 pulses and the cycle frequency is 50 Hz. Subsequently, the mold was immersed in the same palladium colloidal solution as used in Example 1 for 30 minutes. Subsequently, the mold was washed with ion-exchanging water and immersed in an electroless nickel solution for 30 minutes. Consequently, nickel electroless plating could be attached to the laser irradiated region.

### (Example 4)

LCP was used as a polymeric material. As a inorganic filler, 30 weight % of a glass filler having a diameter ϕ of 10 µm was added. Then, this material was subjected to injection molding. A surface of the obtained mold was irradiated with laser beams by using a third harmonic YAG laser under conditions that the fluence is 0.5 J/cm²/pulse, the number of times of irradiation is 200 pulses and the cycle frequency is 10 Hz. Subsequently, the mold was immersed in the same palladium colloidal solution as used in Example 1 for 15 minutes. Subsequently, the mold was washed with ion-exchanging water and immersed in an electroless nickel solution for 15 minutes. Consequently, nickel electroless plating could be attached to the laser irradiated region. It is noted that when an inorganic filler was not added to LCP, plating couldn't be obtained by the processings under the same conditions.

## Claims

1. A pretreatment method for electroless plating, wherein
an inorganic filler is added to a polymeric material; and
an obtained polymeric mold is irradiated with laser and immersed in an anionic noble metal aqueous solution.

2. The pretreatment method for electroless plating according to Claim 1, wherein
10-50 weight % of the inorganic filler is added.

3. The pretreatment method for electroless plating according to of Claim 1 or 2, wherein
a total energy inputted by the laser is 10-500 J/cm².

4. The pretreatment method for electroless plating according to any of Claims 1 to 3, wherein
the laser is irradiated so that a fluence and the number of times of irradiation are set to obtain a charging state suitable for precipitating noble metal.

5. The pretreatment method for electroless plating according to any of Claims 1 to 4, wherein
the polymeric material is LCP, polyethersulfone, polybutylene terephthalate, polycarbonate, polyphenylene ether, polyphenylene oxide, polyacetal, polyethylene terephthalate, polyamide, ABS, polyphenylene sulfide, polyetherimide, polyetherether ketone, polysulfone, polyimide, epoxy resin or a composite resin thereof.

6. The pretreatment method for electroless plating according to any of Claims 1 to 5, wherein
the polymeric material is composed of two or more kinds of resins having different laser ablation threshold values.

7. The pretreatment method for electroless plating according to any of Claims 1 to 6, wherein
a palladium aqueous solution is used as the noble metal aqueous solution.

8. The pretreatment method for electroless plating according to any of Claims 1 to 7, wherein
a glass filler is used as the inorganic filler.
